(19) Europäisches Patentamt
European Patent Office
Office européen des brevets

(11) **EP 1 266 237 B1**

(12) **EUROPÄISCHE PATENTSCHRIFT**

(45) Veröffentlichungstag und Bekanntmachung des Hinweises auf die Patenterteilung:
**23.05.2007 Patentblatt 2007/21**

(21) Anmeldenummer: **01996747.0**

(22) Anmeldetag: **08.11.2001**

(51) Int Cl.:
***G01R 31/36*** *(2006.01)*

(86) Internationale Anmeldenummer:
**PCT/DE2001/004197**

(87) Internationale Veröffentlichungsnummer:
**WO 2002/041014 (23.05.2002 Gazette 2002/21)**

(54) **VERFAHREN UND ANORDNUNG ZUR BESTIMMUNG DES LADEZUSTANDES EINER BATTERIE**

METHOD AND ARRANGEMENT FOR DETERMINATION OF THE STATE OF CHARGE OF A BATTERY

PROCEDE ET AGENCEMENT POUR DETERMINER L'ETAT DE CHARGE D'UNE BATTERIE

(84) Benannte Vertragsstaaten:
**DE ES FR GB IT SE**

(30) Priorität: **17.11.2000 DE 10056969**

(43) Veröffentlichungstag der Anmeldung:
**18.12.2002 Patentblatt 2002/51**

(73) Patentinhaber: **ROBERT BOSCH GMBH**
**70442 Stuttgart (DE)**

(72) Erfinder: **SCHOCH, Eberhard**
**70469 Stuttgart (DE)**

(56) Entgegenhaltungen:
**US-A- 4 390 841          US-A- 5 349 540**
**US-A- 5 381 096**

**Beschreibung**

Technisches Gebiet

Die vorliegende Erfindung betrifft ein Verfahren und eine Anordnung zur Bestimmung des Ladezustands einer Batterie, insbesondere einer Kraftfahrzeug-Starterbatterie.

Stand der Technik

Zur Ladezustandsbestimmung von Kraftfahrzeug-Starterbatterien sind verschiedene Verfahren bekannt. Als Beispiele seien genannt Verfahren, die den Ladezustand durch eine Stromintegration mit Rekalibrierung durch die an der nach längerer Zeit, typischerweise 4 bis 5 Stunden, stromlosen Batterie messbaren ladezustandsproportionalen Ruhespannung ermitteln. Ein derartiges Verfahren ist in der DE 35 20 985 C2 beschrieben. Ferner sei auf modelbasierte Verfahren hingewiesen, die die Bestimmung der Ruhespannung und damit des aus dieser Ruhespannung ableitbaren Ladezustands auch bei belasteter Batterie durch Adaption eines Modells an die reale Batterie mit Hilfe von Sensorgrößen wie Batteriespannung, Batteriestrom und/oder Batterietemperatur ermöglichen.

Die erstgenannten Verfahren sind relativ einfach realisierbar, führen jedoch bei langen Fahrzeugbetriebsphasen mit relativ kurzen oder nur wenigen Ruhezeiten (beispielsweise Taxibetrieb) zu Fehlern, da der Ladezustand nur selten über eine Ruhespannungsmessung rekalibriert oder korrigiert werden kann.

Modellbasierte Verfahren sind im Gegensatz dazu zur Rekalibrierung nicht auf Ruhephasen angewiesen, wobei die Realisierung derartiger Verfahren je nach Komplexität des zugrundegelegten Batteriemodells relativ aufwendig ist.

Mit der Erfindung wird die Bereitstellung einer möglichst einfachen und unaufwendigen Ladezustandserkennung für Kraftfahrzeug-Starterbatterien, insbesondere für Batterien, welche im Rahmen eines Fahrzeugbetriebes ohne Ruhezeiten, beispielsweise Taxibetrieb, zum Einsatz kommen, angestrebt.

Dieses Ziel wird erreicht durch ein Verfahren mit den Merkmalen des Patentanspruchs 1 sowie eine Anordnung mit den Merkmalen des Patentanspruchs 7.

Erfindungsgemäß wird ein einfaches Batteriemodell zur Rekalibrierung der Stromintegration verwendet. Aufgrund des einfachen Modellansatzes mit wenigen Parametern kann das eingesetzte Schätzverfahren für den Ladezustand gleichzeitig auch zur Schätzung von unbekannten Parametern eingesetzt werden, ohne dass ein eigener Parameterschätzer erforderlich wäre, wie er beispielsweise in der DE-P 199 59019.2 beschrieben ist.

Aus der US-A-4390841 ist ein Verfahren zur Bestimmung des Ladezustands einer Batterie bekannt, bei dem in einem ersten Arbeitsbereich der Batterie der Ladezustand auf Grundlage einer Modellrechnung bestimmt wird. In dieser Modellrechnung wird eine gemessene und eine berechnete Batteriespannung mittels einer Rückkopplung aneinander angeglichen.

Im Gegensatz zu bekannten modellbasierten Verfahren zur Ladezustandsbestimmung, welche mit aufwendigen Batteriemodellen arbeiten, die einen großen Dynamikbereich sowie einen weiten Arbeitsbereich bezüglich Temperatur, Strom und Ladezustand abdecken, wird erfindungsgemäß ein Modell verwendet, das nur Zeitkonstanten in der Größenordnung von Minuten bis Stunden berücksichtigt. Hierdurch kann das Modell einfach gehalten werden und besitzt nur wenige zu bestimmende Parameter.

Das dargestellte Verfahren wird vorteilhafterweise nur in einem gültigen Arbeitsbereich des Modells aktiviert.

Zweckmäßigerweise wird der erste Arbeitsbereich, in dem das erfindungsgemäße Verfahren angewendet wird, über das Überschreiten eines Mindestbatteriestromes $I_{Batt,min}$ definiert. Die Beschränkung des erfindungsgemäß eingesetzen Modells auf diesen Arbeitsbereich bzw. den Entladebereich der Batterie ist im Hinblick auf Anwendungen zur Überwachung eines Mindestladezustands akzeptabel und führt in der Praxis zu befriedigenden Ergebnissen.

Vorteilhafterweise wird auf der Grundlage der Modellrechnung eine Ruhespannung der Batterie berechnet, aus welcher der Batteriezustand ableitbar ist. Derartige Zusammenhänge zwischen Ruhespannung und Ladezustand der Batterie sind an sich bekannt und bedürfen keiner weiteren Erläuterung.

Zweckmäßigerweise wird der Batteriezustand soc gemäß einer Funktion der Formel

$$\text{soc} = f(U_R) = (U_R - U_{R,min})/(U_{R,max} - U_{R,min}) \tag{1}$$

bestimmt. Hierbei bezeichnen $U_{R,min}$ bzw. $U_{R,max}$ die minimale bzw. maximale Ruhespannung bei den vom Batteriehersteller angegebenen Werten der Säuredichte für eine leere bzw. vollgeladene Batterie.

Gemäß einer besonders bevorzugten Ausführungsform der Erfindung erfolgt bei Vorliegen eines zweiten Arbeitsbereiches der Batterie die Bestimmung des Ladezustands auf der Grundlage einer Messung des Batteriestroms und einer zuletzt berechneten oder geschätzten Ruhespannung $U_{RO}$. Bildet man das Stromintegral gemäß der Formel $Q = -\int I_{Batt} dt$, lässt sich auf diese Weise eine aktuelle Ruhespannung $U_R$ gemäß einer Gleichung der Form $U_R = U_{R0} + Q/C$ berechnen. Auch hier bietet es sich an, den aktuellen Ladezustand auf der Grundlage der oben angegebenen Gleichung (1) zu berechnen.

Zweckmäßigerweise wird der zweite Arbeitsbereich dann angenommen, wenn der Batteriestrom kleiner als der Mindestbatteriestrom $I_{Batt,min}$ ist.

Durch die Unterscheidung der zwei erwähnten Arbeitsbereiche, für die einerseits $I_{Batt} > I_{Batt,min}$, und andererseits $I_{Batt} <= I_{Batt,min}$ gilt, lässt sich über den gesamten Batteriearbeitsbereich eine adäquate Abschätzung des Ladezustands der Batterie ausführen.

Weitere Vorteile der Erfindung ergeben sich aus der folgenden Darstellung bevorzugter Ausführungsbeispiele.

<u>Zeichnung</u>

Bevorzugte Ausführungsformen der Erfindung werden nun unter Bezugnahme auf die beigefügte Zeichnung näher beschrieben. In dieser zeigt

Fig. 1      ein elektrisches Ersatzschaltbild einer Batterie, und
Fig. 2      ein schematisches Blockschaltbild zur Darstellung der erfindungsgemäß vorgesehenen Ladezustandserkennung.

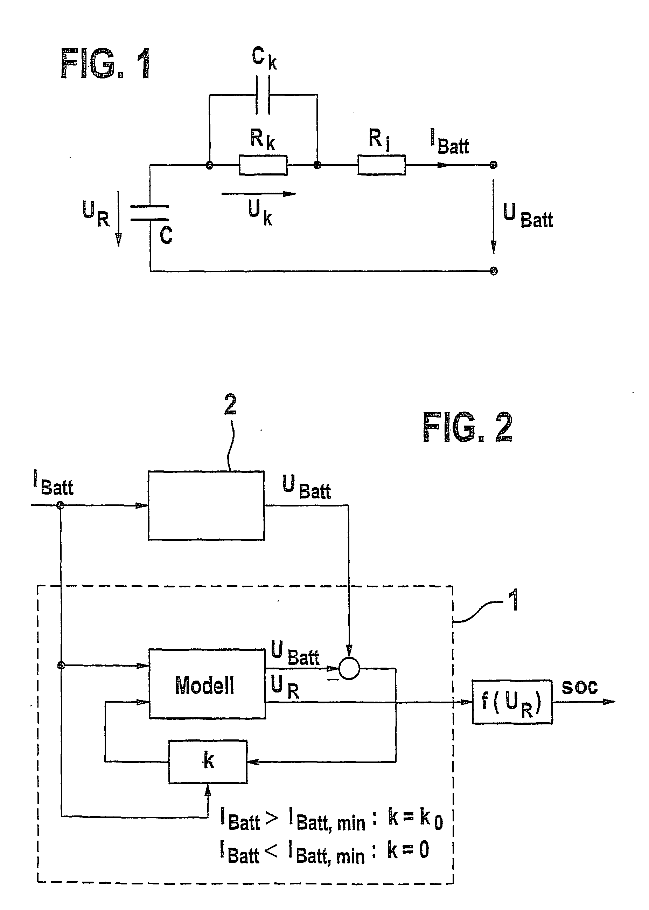

In Fig. 1 ist ein elektrisches Ersatzschaltbild einer Batterie, bei welcher das erfindungsgemäße Verfahren beispielsweise anwendbar ist, dargestellt. Hierin beschreibt die Kapazität C den nahezu linearen Zusammenhang zwischen der Ladung Q der Batterie und der Ruhespannung $U_R$ der Batterie. Die Konzentrationsüberspannung $U_K$ bildet über die Kapazität $C_K$ und den Widerstand $R_K$ die Dynamik des Säuredichteausgleichs zwischen den Plattenporen und dem freien Säurevolumen nach. Der Innenwiderstand $R_i$ der Batterie beinhaltet die ohmschen Widerstände von Elektroden und Elektrolyt sowie den Übergangswiderstand der Doppelschicht zwischen Elektroden und Elektrolyt. Mit $I_{Batt}$ bzw. $U_{Batt}$ sind schließlich der Batteriestrom bzw. Entladestrom sowie die Batteriespannung bezeichnet.

Das erfindungsgemäße Verfahren wird nun weiter unter Bezugnahme auf Fig. 2 erläutert. Eine Batterie ist hier insgesamt mit 2 bezeichnet. Die Batterie 2 weist einen Batteriestrom $I_{Batt}$ und eine Batteriespannung $U_{Batt}$ auf, welche jeweils gemessen werden. Der Batteriestrom $I_{Batt}$ wird wie dargestellt in eine Modellrechnung eingegeben. Die Batteriespannung $U_{Batt}$ wird, abgeglichen mit einer berechneten bzw. einer geschätzten Batteriespannung $U_{Batt}$, abgeglichen und ebenfalls als Eingangsgröße in das Modell eingegeben.

Aus dem so berechneten Ruhespannungswert $U_R$ wird, wie unten weiter erläutert wird, der Ladezustand der Batterie bestimmt.

Zunächst sei vorausgesetzt, dass der Batteriestrom $I_{Batt}$ größer als ein minimaler Batteriestrom $I_{Batt,min}$ ist, d.h. die Batterie befindet sich in ihrem Entlade-Arbeitsbereich. Für diesen Arbeitsbereich wird nun zur Schätzung der Ruhespannung $U_R$, der Konzentrationsüberspannung $U_K$ sowie des Innenwiderstands $R_i$ ein Beobachter, beispielsweise in Form eines (gestrichelt umrandeten) Kalman-Filters 1 eingesetzt. Zu diesem Zwecke wird das verwendete Modell durch Rückkopplung des Fehlers $U_{Batt} - U_{Batt}$, zwischen gemessener und berechneter Batteriespannung abgeglichen. Sind die Parameter C, $R_K$ und $C_K$ beispielsweise nach einem Batterietausch unbekannt, können auch diese in die Schätzung miteinbezogen werden.

Der Modellabgleich findet, wie bereits erwähnt, nur in den für die Modellgültigkeit relevanten Arbeitspunkten statt, d.h. für $I_{Batt} > I_{Batt,min}$ (Entladestrom > 0). Das heißt, für diesen Fall wird ein Wert $k = k_0 = U_{Batt} - U_{Batt}$, in die Modellrechnung eingespeist.

In den übrigen Arbeitspunkten, für die gilt $I_{Batt} \leq I_{Batt,min}$, wird die Rückkopplung des Fehlers in die Modellrechnung unterbrochen, d.h. k wird gleich 0 gesetzt. In diesem zweiten Arbeitsbereich wird die Ruhespannung $U_R$ aus dem Stromintegral $Q = -\int I_{Batt} dt$ und der zuletzt, insbesondere während des Vorliegens des ersten Arbeitsbereiches, geschätzten Ruhespannung $R_0$ gemäß der Gleichung $U_R = U_{R0} + Q/C$ berechnet.

Für beide Arbeitsbereiche wird der sich aus der Rechnung ergebende Ruhespannungswert $U_R$ einer weiteren funktionalen Beaufschlagung zum Erhalt des Batteriezustands soc (State of Charge) unterzogen. Der Batteriezustand wird zweckmäßigerweise gemäß einer Gleichung der Formel

$$\mathrm{soc} = f(U_R) = (U_R - U_{R.min}) / (U_{R,max} - U_{R,min})$$

bestimmt.

$U_{R,min}$ bzw. $U_{R,max}$ bezeichnen, wie bereits erwähnt, die minimale bzw. die maximale Ruhespannung bei den vom Batteriehersteller angegebenen Werten der Säuredichte für eine leere bzw. vollgeladene Batterie.

**Patentansprüche**

1. Verfahren zur Bestimmung des Ladezustands soc einer Kraftfahrzeug-Starterbatterie, bei dem bei Vorliegen eines ersten Arbeitsbereiches der Batterie der Ladezustand auf der Grundlage einer Modellrechnung, in welcher eine gemessene und eine berechnete Batteriespannung $U_{Batt}$, $U_{Batt'}$ über eine Rückkopplung abgeglichen werden, berechnet wird, **dadurch gekennzeichnet, dass** der erste Arbeitsbereich dann angenommen wird, wenn ein Batteriestrom bzw. Entladestrom größer als ein Mindestbatteriestrom $I_{Batt,min}$ bzw. ein minimaler Batteriestrom ist.

2. Verfahren nach einem der Ansprüche 1,
   **dadurch gekennzeichnet,**
   **dass** auf der Grundlage der Modellrechnung eine Ruhespannung $U_R$ der Batterie berechnet wird, aus welcher der Batterieladezustand soc ableitbar ist.

3. Verfahren nach einem der vorstehenden Ansprüche,
   **dadurch gekennzeichnet,**
   **dass** der Batterieladezustand soc gemäß einer Funktion der Form soc = $f(U_R)$ = $(U_R - L)_{R,min}$ /$U_{R,max}$ - $U_{R,min}$) berechnet wird.

4. Verfahren nach einem der vorstehenden Ansprüche,
   **dadurch gekennzeichnet.**
   **dass** bei Vorliegen eines zweiten Arbeitsbereiches der Batterie der Ladezustand auf der Grundlage einer Messung des Batteriestromes und einer zuletzt, insbesondere während des Vorliegens des ersten Arbeitsbereiches, berechneten oder geschätzten Ruhespannung ermittelt wird.

5. Verfahren nach einem der vorstehenden Ansprüche,

6. Anordnung zur Bestimmung des Ladezustands einer Kraftfahrzeug-Starterbatterie mit einer Beobachtungseinrichtung, die ein Kalman-Filter (1) umfasst, und in einem ersten Arbeitsbereich der Batterie auf der Grundlage einer Modellrechnung, in welche eine gemessene und eine berechnete Batteriespannung über Rückkopplung miteinander abgeglichen werden, den Ladezustand der Batterie durch Berechnung einer Ruhespannung bestimmt, **dadurch gekennzeichnet, dass** die Beobachtungseinrichtung in einem zweiten Arbeitsbereich der Batterie den Ladezustand auf der Grundlage einer Messung des Batteriestromes und einer zuletzt, insbesondere während des Vorliegens des ersten Arbeitsbereiches, berechneten oder geschätzten Ruhespannung der Batterie bestimmt.

**Claims**

1. Method for determination of the state of charge soc of a motor-vehicle starter battery, in which, when the battery is in a first operating range, the state of charge is calculated on the basis of a model calculation, in which a measured and a calculated battery voltage $U_{Batt}$, $U_{Batt}$, are matched via feedback, **characterized in that** the first operating range is assumed when the battery current or discharge current is greater than a minimum battery current $I_{Batt,min}$, or a minimal battery current.

2. Method according to Claim 1,
   **characterized in that**
   a rest voltage $U_R$ of the battery, from which the battery state of charge soc can be derived, is calculated on the basis of the model calculation.

3. Method according to one of the preceding claims,
   **characterized in that**
   the battery state of charge soc is calculated using a function in the form soc = $f(U_R)$ = $(U_R - U_{R,min})$ / $(U_{R,max} - U_{R,min})$.

4. Method according to one of the preceding claims,
   **characterized in that**

when the battery is in a second operating range, the state of charge is determined on the basis of a measurement of the battery current and a rest voltage which has been calculated or estimated most recently, in particular when the battery is in a first operating range.

5. Method according to one of the preceding claims,
**characterized in that**
the second operating range is assumed when the battery current is less than or equal to the minimum battery current $I_{Batt,min}$.

6. Arrangement for determination of the state of charge of a motor-vehicle starter battery having an observation device which has a Kalman filter (1), and, when the battery is in a first operating range, the state of charge of the battery is determined by calculation of a rest voltage on the basis of a model calculation in which a measured and a calculated battery voltage are matched to one another via feedback,
**characterized in that**
when the battery is in the second operating range, the observation device determines the state of charge on the basis of a measurement of the battery current and a rest voltage of the battery which has been calculated or estimated most recently, in particular when the battery is in the first operating range.


**Revendications**

1. Procédé pour déterminer l'état de charge (soc) d'une batterie de démarreur de véhicule automobile, suivant lequel, en présence d'une première zone de travail de la batterie, l'état de charge est calculé sur la base d'un modèle dans lequel une tension de batterie mesurée et une tension de batterie calculée ($U_{batt}$, $U_{batt'}$) sont ajustées entre elles par l'intermédiaire d'une rétroaction,
**caractérisé en ce que**
la première zone de travail est admise lorsqu'un courant de batterie ou courant de décharge est supérieur à un courant de batterie le plus bas $I_{batt,min}$ ou minimal.

2. Procédé selon la revendication 1,
**caractérisé en ce que**
sur la base du modèle, on calcule une tension de repos $U_R$ de la batterie à partir de laquelle l'état de charge (soc) de la batterie peut être dérivé.

3. Procédé selon l'une des revendications précédentes,
**caractérisé en ce que**
l'état de charge (soc) de la batterie est calculé suivant une fonction de la forme : soc = f($U_R$) = ($U_R$ - $U_{R,min}$)/($U_{R,max}$ - $U_{R,min}$).

4. Procédé selon l'une des revendications précédentes,
**caractérisé en ce qu'**
en présence d'une seconde zone de travail de la batterie, l'état de charge est déterminé sur la base d'une mesure du courant de batterie et d'une tension de repos calculée ou estimée en dernier lieu, en particulier durant la présence de la première zone de travail.

5. Procédé selon l'une des revendications précédentes,
**caractérisé en ce que**
la seconde zone de travail est admise lorsque le courant de batterie est inférieur ou égal au courant de batterie minimal $I_{batt,min}$.

6. Agencement pour déterminer l'état de charge d'une batterie de démarreur de véhicule automobile, comportant un dispositif d'observation qui comprend un filtre de Kalman (1) et qui détermine dans une première zone de travail de la batterie - sur la base d'un modèle dans lequel une tension de batterie mesurée et une tension de batterie calculée sont ajustées entre elles par l'intermédiaire d'une rétroaction - l'état de charge de la batterie par le calcul d'une tension de repos,
**caractérisé en ce que**
le dispositif d'observation détermine, dans une seconde zone de travail de la batterie, l'état de charge sur la base d'une mesure du courant de batterie et d'une tension de repos de la batterie calculée ou estimée en dernier lieu, en particulier durant la présence de la première zone de travail.

## FIG. 1

## FIG. 2